# EUROPEAN PATENT APPLICATION

(11) **EP 2 355 344 A2**
(43) Date of publication of application: **10.08.2011**
(21) Application number: 11153442.6
(22) Date of filing: 04.02.2011
(51) Int. Cl.: H03H 9/10, H03H 9/05, H03H 9/17

(54) **Piezoelectric vibrator and oscillator using the same**

(30) Priority: 05.02.2010 JP 2010024656
(71) Applicant: Seiko Instruments Inc., Chiba-shi, Chiba (JP)
(72) Inventor: Tange, Yoshihisa, Chiba-shi, Chiba (JP)
(74) Representative: Cloughley, Peter Andrew

(57) **Abstract**

In a piezoelectric vibrator in which a piezoelectric vibrating reed is mounted on a mounting portion installed on a surface of the base substrate in a cantilevered state and the piezoelectric vibrating reed is accommodated to be covered by a lid substrate, the resistance of a lead-out electrode for supplying a drive power to the piezoelectric vibrating reed is reduced, thereby preventing degradation of vibrating performance. A first lead-out electrode is formed between a first through-electrode and a mounting portion formed on a base substrate, a second lead-out electrode is formed on a surface of a lid substrate on the base substrate side, the first and second lead-out electrodes are electrically connected to the first and second connection portions in the vicinities of the mounting portion and the first through-electrode, respectively, thereby reducing the resistance of the lead-out electrode.

## Description

The present invention relates to a piezoelectric vibrator which encloses a piezoelectric vibrating reed in a cavity provided between substrates and an oscillator using the same, and more particularly, to a small-sized piezoelectric vibrator.

In recent years, piezoelectric vibrators using crystals or the like have been used as time sources or timing sources for portable phones or portable information terminal devices. Various types of piezoelectric vibrators are known, and as an example, a surface-mounted piezoelectric vibrator is known. As the surface-mounted piezoelectric vibrator, there is one known having a three-layer structure type in which a piezoelectric substrate provided with a piezoelectric vibrating reed is interposed between a base substrate and a lid substrate in the vertical direction. The piezoelectric vibrating reed is accommodated in a cavity provided between the base substrate and the lid substrate. Recently, a piezoelectric vibrator with a two-layer structure type has been developed. In this type, a cavity is formed of a concave portion provided on an inner surface of the base substrate or the lid substrate, a piezoelectric vibrating reed is mounted on a surface of the base substrate, and the lid substrate is directly bonded to a periphery of the base substrate to accommodate the piezoelectric vibrating reed in the corresponding cavity. The piezoelectric vibrator with a two-layer structure type is excellent because it can achieve a reduction in thickness compared to the three-layer structure type (for example, refer to JP-A-2009-232449).

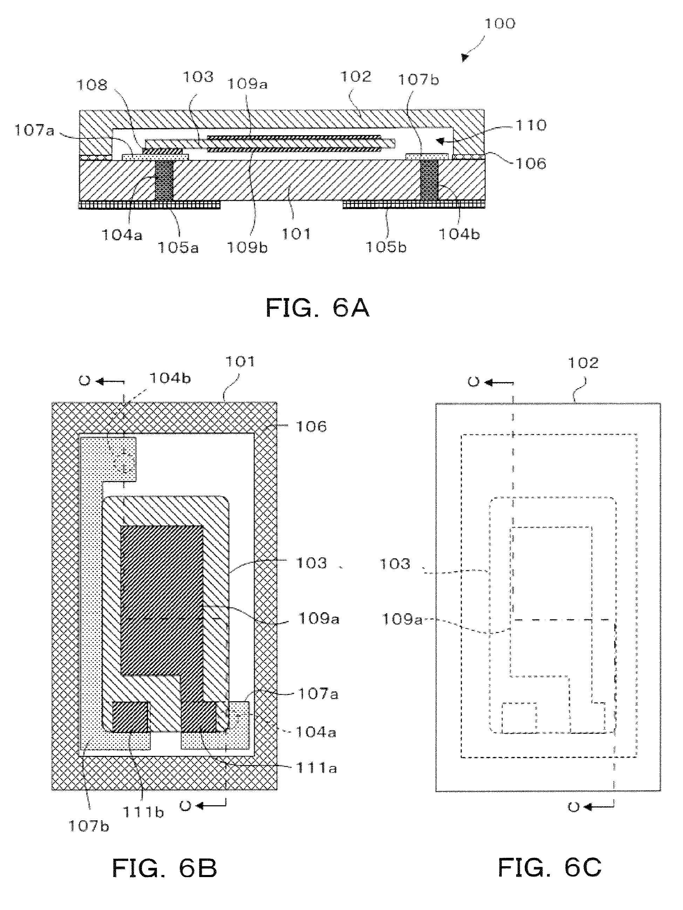

Figs. 6A to 6C are explanatory views of a piezoelectric vibrator 100 having a two-layer structure type. Fig. 6A is a cross-sectional view schematically illustrating the piezoelectric vibrator 100, Fig. 6B is a top view schematically illustrating a base substrate 101 which is a lower substrate, and Fig. 6C is a top view schematically illustrating a lid substrate 102 which is an upper substrate. Moreover, Fig. 6A illustrates a cross-section taken along the line C-C of the top views of Figs. 6B and 6C.

As illustrated in Fig. 6A, the piezoelectric vibrator 100 includes the base substrate 101, the lid substrate 102 bonded to an upper surface of an outer periphery of the base substrate 101 via a bonding material 106, and a piezoelectric vibrating reed 103 mounted on the upper surface of the base substrate 101 in a cantilevered state. The surface of the lid substrate 102 on the base substrate 101 side is provided with a cavity 110 as a concave portion so as to accommodate the piezoelectric vibrating reed 103.

A crystal plate is used for the piezoelectric vibrating reed 103. Through-electrodes 104a and 104b are implanted in the base substrate 101, and outer electrodes 105a and 105b and lead-out electrodes 107a and 107b are respectively connected to an outer surface and an inner surface of the base substrate 101. The piezoelectric vibrating reed 103 is mounted on the lead-out electrodes 107a and 107b.

As illustrated in Fig. 6B, the two through-electrodes 104a and 104b are provided in substantially diagonal portions, the lead-out electrode 107b is formed from a corner portion of an upper side to a corner portion of a lower side, and the lead-out electrode 107a is formed on an upper surface of the through-electrode 104a and on the base substrate 101 in the vicinity thereof. In addition, a mounting member 108 is formed on upper surfaces of the lead-out electrodes 107a and 107b, and the piezoelectric vibrating reed 103 is held thereon in the cantilevered state.

Excitation electrodes 109a and 109b are provided on both surfaces of the piezoelectric vibrating reed 103 to be opposite to each other, are electrically connected to terminal electrodes 111 a and 111 b provided under end portions of a lower side of the piezoelectric vibrating reed 103, and are respectively connected to the lead-out electrodes 107a and 107b via the mounting member 108. Therefore, the outer electrode 105a is electrically connected to the excitation electrode 109a via the through-electrode 104a, the lead-out electrode 107a, the mounting member 108, and the terminal electrode 111 a. In addition, the outer electrode 105b is electrically connected to the excitation electrode 109b via the through-electrode 104b, the lead-out electrode 107b, the mounting member 108, and the terminal electrode 111b. That is, drive power is applied to the excitation electrodes 109a and 109b from the outer electrodes 105a and 105b to excite the piezoelectric vibrating reed 103, thereby generating a signal having a predetermined period.

In recent years, reduction in the sizes of portable devices and portable terminals has been progressing. With this, a reduction in the size of the piezoelectric vibrator 100 is also required. When the size of the piezoelectric vibrator 100 is reduced, the sizes of the piezoelectric vibrating reed 103 and the lead-out electrode 107 and areas of the bonding material 106 need to be reduced. However, for example, in a case where a crystal plate is used for the piezoelectric vibrating reed 103, if the size of the piezoelectric vibrating reed 103 is reduced, the Cl value (crystal impedance value) is increased, and thus vibration characteristics are deteriorated. In addition, in order to stabilize the vibrations of the piezoelectric vibrating reed 103, the inside of the cavity 110 has to be blocked from the air. For example, the cavity 110 is maintained in a vacuum state. Accordingly, the bonding material 106 needs to have a certain degree of width.

In addition, when a parasitic capacitance occurs between the lead-out electrode 107b and the excitation electrode 109, the vibration characteristics are deteriorated. Accordingly, the lead-out electrodes 107b and the excitation electrode 109 need not to be overlapped with each other in a plan view. In addition, the base substrate 101 and the lid substrate 102 are heated when bonded to each other via the bonding material 106. Then, there may be a case where wiring resistance of the lead-out electrodes 107a and 107b is increased. In this point of view, in a case where the size of the piezoelectric vibrator 100 is reduced, the size of the piezoelectric vibrating reed 103 or the width of the bonding material 106 cannot be reduced by a necessary amount or greater, and consequently, when the reduction in the size of the piezoelectric vibrator 100 is continued, the width of the lead-out electrode 107b is reduced and thus the resistance is increased, also resulting in deterioration of the vibration characteristics.

In order to solve the above problems, an object of the invention is to provide a piezoelectric vibrator capable of achieving a reduction in the size without deterioration of vibration characteristics.

A piezoelectric vibrator according to the invention includes: a base substrate; a piezoelectric vibrating reed which is held on a mounting portion formed on a surface of the base substrate in a cantilevered state; and a lid substrate which is installed on the base substrate and covers and accommodates the piezoelectric vibrating reed, wherein the piezoelectric vibrating reed has first and second excitation electrodes on outer surfaces thereof for driving, the base substrate has first and second through-electrodes which penetrate from the surface thereof to the rear surface on the reverse side, a first lead-out electrode which is formed on the surface thereof and has one end connected to the first through-electrode and the other end connected to the mounting portion, a first connection portion positioned on the first lead-out electrode in the vicinity of the mounting portion, and a second connection portion positioned in the vicinity of the first through-electrode, the lid substrate has a second lead-out electrode formed on a surface on a side on which the piezoelectric vibrating reed is mounted, and the first and second lead-out electrodes are electrically connected to each other via the first and second connection portions, and the first excitation electrode is electrically connected to the first through-electrode via the mounting portion and the first and second lead-out electrodes, and the second excitation electrode is electrically connected to the second through-electrode via the mounting portion.

In addition, preferably the piezoelectric vibrating reed has a flat plate shape, and the first and second excitation electrodes are formed on the front and the rear surface of the flat panel shape to be opposite to each other, and the first and second lead-out electrodes are installed at positions so as not to overlap with the first and second excitation electrodes as viewed in a direction normal to the surface of the base substrate.

In addition, preferably the lid substrate has a concave portion for accommodating the piezoelectric vibrating reed, an upper surface of a side wall of the concave portion is bonded to the base substrate, first and second stepped portions are formed between the upper surface of the side wall and a bottom surface of the concave portion, first and second stepped electrodes are formed on upper and side surfaces of the first and second stepped portions, respectively, and the first stepped electrode electrically connects one end of the second lead-out electrode to the first connection portion, and the second stepped electrode electrically connects the other end of the second lead-out electrode to the second connection portion.

An oscillator according to the invention includes: the piezoelectric vibrator according to any of the above descriptions; and a drive circuit for supplying a drive signal to the piezoelectric vibrator.

According to the invention, with regard to wires between the mounting portion and the first through-electrode, the first lead-out electrode formed on the base substrate is connected in parallel to the second lead-out electrode formed on the lid substrate, so that the resistance of the wires is reduced, thereby providing the small-sized piezoelectric vibrator which prevents degradation of vibration characteristics.

Embodiments of the present invention will now be described by way of further example only and with reference to the accompanying drawings, in which:
Figs. 1A and 1B are explanatory views of a piezoelectric vibrator according to an embodiment of the invention.
Figs. 2A and 2B are top views schematically illustrating the piezoelectric vibrator according to the embodiment of the invention.
Figs. 3A and 3B are longitudinal cross-sectional views schematically illustrating the piezoelectric vibrator according to the embodiment of the invention.
Figs. 4A and 4B are longitudinal cross-sectional views schematically illustrating the piezoelectric vibrator according to the embodiment of the invention.
Fig. 5 is a top view schematically illustrating an oscillator according to the embodiment of the invention.
Figs. 6A to 6C are explanatory views of a well-known piezoelectric vibrator.

A piezoelectric vibrator according to the invention includes: a base substrate; a piezoelectric vibrating reed which is held on a mounting portion formed on a surface of the base substrate in a cantilevered state; and a lid substrate which covers and accommodates the piezoelectric vibrating reed and is bonded with a bonding portion on a peripheral portion of the base substrate. The piezoelectric vibrating reed has first and second excitation electrodes on its surface and the rear surface for causing excitation of the piezoelectric vibrating reed. The base substrate has first and second through-electrodes which penetrate from the surface thereof to the rear surface on the reverse side, a first lead-out electrode which is formed on the surface thereof and has one end connected to the first through-electrode and the other end connected to the mounting portion, a first connection portion positioned on the first lead-out electrode in the vicinity of the mounting portion, and a second connection portion positioned in the vicinity of the first through-electrode. The lid substrate has a second lead-out electrode formed on a surface on a side on which the piezoelectric vibrating reed is mounted, and the first and second lead-out electrodes are electrically connected to each other via the first and second connection portions. The first excitation electrode is electrically connected to the first through-electrode via the mounting portion and the first and second lead-out electrodes, and the second excitation electrode is electrically connected to the second through-electrode via the mounting portion.

When the outer shape of the piezoelectric vibrator is reduced, it becomes difficult to form the first and second through-electrodes to be close in one side of the base substrate. Here, the first and second through-electrodes may be formed at positions on the surface of the base substrate as far apart as possible. On the other hand, the piezoelectric vibrating reed needs to be installed on the mounting portion in the cantilevered state. Accordingly, when the lead-out electrode is formed on the base substrate, the lead-out electrode needs to be drawn from any one of or both of the first and second through-electrodes which are separated from each other so as to be connected to the mounting portion. According to the invention, the lead-out electrodes are formed both on the base substrate and the lid substrate and are electrically connected to each other via the first and second connection portions. That is, between the mounting portion and the first through-electrode, the first lead-out electrode installed on the base substrate is connected to the second lead-out electrode formed on the lid substrate in parallel, thereby reducing the resistance between the mounting portion and the first through-electrode.

Moreover, the base substrate and the lid substrate may be made of a glass substrate. When the glass substrate is used, a molding process can be easily performed compared to a case where a ceramic substrate is used. In addition, since the glass material has a low thermal conductivity, an external temperature change is less likely to be transmitted to the piezoelectric vibrating reed, and a rapid temperature change is less likely to be influenced thereon. In addition, since the glass substrate is transparent, trimming can be performed using laser light after a package is assembled. In addition, the base substrate and the lid substrate can be bonded by anodic bonding, so that airtightness of the package can be maintained for a long time.

A crystal substrate in an AT mode can be used for the piezoelectric vibrating reed. A conductive adhesive material or a metal bump can be used for the mounting portion. When the metal bump is used, the piezoelectric vibrating reed can be mounted within a short time, so that adhesion of the piezoelectric vibrating reed in the cantilevered state can be easily performed. A conductive adhesive material or a metal bump may be used as the connection portion.

In addition, the first and second excitation electrodes can be formed to be opposite to each other with the piezoelectric vibrating reed interposed therebetween, and the first and second lead-out electrodes can be installed at positions so as not to overlap with the first and second excitation electrodes as viewed in a direction normal to the surface of the base substrate. Accordingly, parasitic capacitance that occurs between the first and second lead-out electrodes and the first and second excitation electrodes can be reduced, thereby stabilizing vibrations of the piezoelectric vibrating reed.

In addition, the concave portion for accommodating the piezoelectric vibrating reed in the lid substrate can be formed. The upper surface of the side wall of the concave portion is bonded to the peripheral portion of the base substrate. The second lead-out electrode is formed on the bottom surface of the concave portion. In this case, first and second stepped portions can be formed between the bottom surface of the concave portion and the upper surface of the side wall thereof, and first and second stepped electrodes formed on upper and side surfaces of the first and second stepped portions. In addition, the first stepped electrode electrically connects one end of the second lead-out electrode to the first connection portion, and the second stepped electrode electrically connects the other end of the second lead-out electrode to the second connection portion.

As such, the first and second stepped portions are formed at positions where the first and second connection portions are installed, and when the second lead-out electrode is connected via the first and second stepped electrodes, stepped amounts of the first and second stepped portions and heights of the first and second connection portions can be reduced. For example, when the stepped portions are formed such that the surface of the piezoelectric vibrating reed on the mounting portion side and the upper surface of the first and second stepped portions are substantially the same distance from the surface of the base substrate, the mounting portion and the first and second connection portions can be simultaneously formed in the same step. For example, in a case where the mounting portion and the first and second connection portions are formed of metal bumps, bumps of the same metal are placed in the same step and are connected (flip chip connection) in the same step. Hereinafter, detailed description will be provided with reference to the accompanying drawings.

### First Embodiment

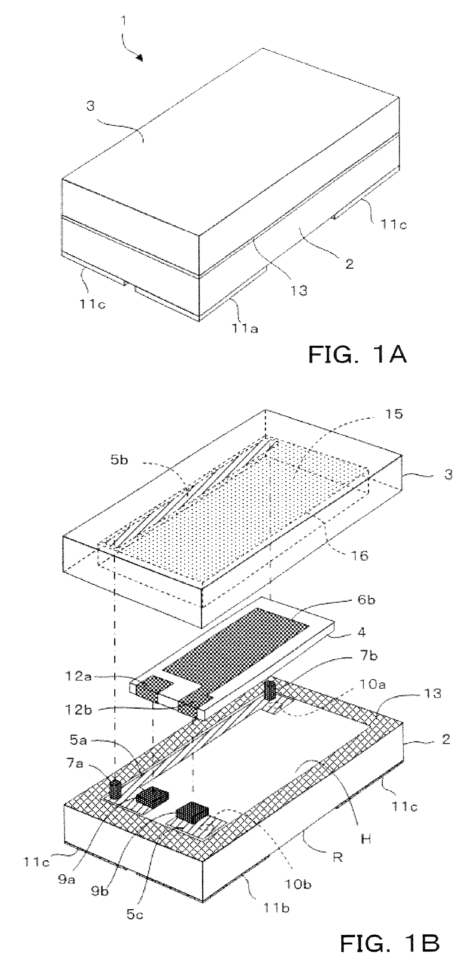

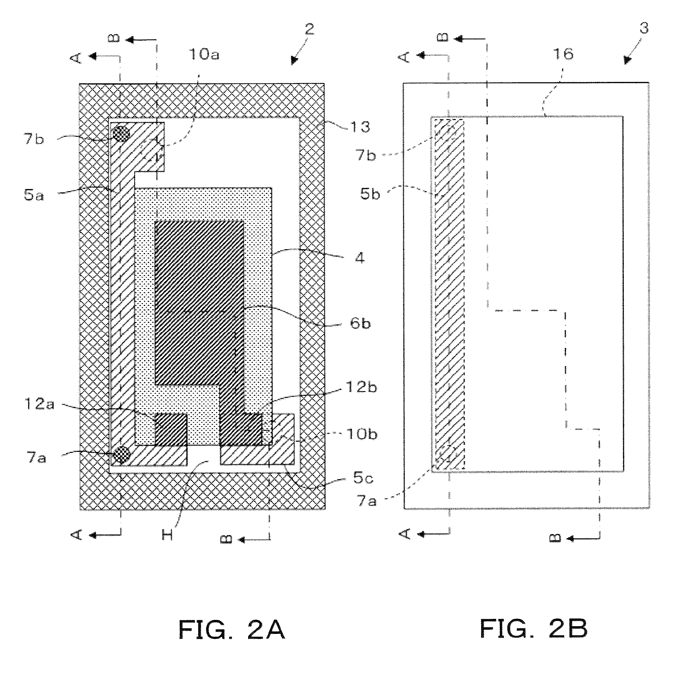

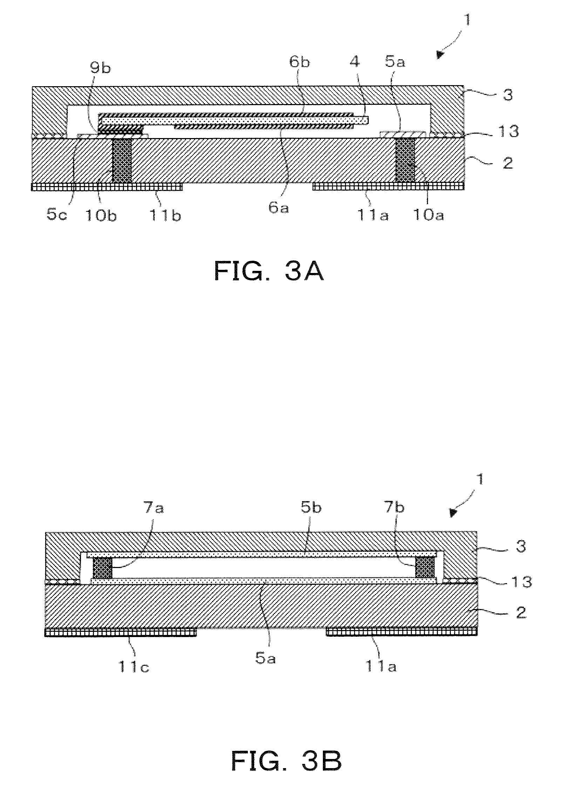

A piezoelectric vibrator 1 according to a first embodiment of the invention will be described with reference to Figs. 1A to 3B. Figs. 1A and 1B are explanatory views of the piezoelectric vibrator 1. Fig. 1A is a diagram of an outer appearance of the piezoelectric vibrator 1, and Fig. 1B is an exploded perspective view thereof. Figs. 2A and 2B are top views schematically illustrating the piezoelectric vibrator 1. Fig. 2A is a top view schematically illustrating a base substrate 2 on which a piezoelectric vibrating reed 4 is mounted, and Fig. 2B is a top view schematically illustrating a lid substrate 3. Figs. 3A and 3B are longitudinal cross-sectional views schematically illustrating the piezoelectric vibrator 1. Fig. 3A is a cross-sectional view schematically illustrating the piezoelectric vibrator 1 taken along the line B-B, and Fig. 3B is a cross-sectional view schematically illustrating the piezoelectric vibrator 1 taken along the line A-A. Like elements which are the same or have the same functions are denoted by like reference numerals.

As illustrated in Figs. 1A and 1B, the piezoelectric vibrator 1 includes the base substrate 2, the piezoelectric vibrating reed 4 mounted on a surface of the base substrate 2, and the lid substrate 3 which is provided with a concave portion 16 so that an upper surface of a side wall of the concave portion 16 is bonded to a peripheral portion of the base substrate 2 via a bonding member 13. Here, a crystal plate that vibrates in an AT mode is used for the piezoelectric vibrating reed 4. A glass material is used for the base substrate 2 and the lid substrate 3. The base substrate 2 and the lid substrate 3 are bonded to each other by anodic bonding. A long side of the piezoelectric vibrator 1 having a rectangular shape has a length of equal to or smaller than several millimeters and a thickness of equal to or smaller than 0.1 mm.

The base substrate 2 has a rectangular shape. The base substrate 2 includes two through-electrodes 10a and 10b which penetrate from a surface H to a rear surface R in diagonally opposite corner regions, and the bonding member 13 is provided on a peripheral portion of the surface H. The base substrate 2 includes first and third lead-out electrodes 5a and 5c on an inner peripheral side of the bonding member 13 in the vicinity of one short side, first and second mounting portions 9a and 9b formed on the first and third lead-out electrodes 5a and 5c, and a first connection portion 7a formed on the first lead-out electrode 5a. In addition, the base substrate 2 includes the first lead-out electrode 5a extending from the vicinity of the one short side on the inner peripheral side of the bonding member 13 to the vicinity of the other short side, and a second connection portion 7b formed thereon. The rear surface R of the base substrate 2 includes a second outer electrode 11 b electrically connected to the second through-electrode 10b on the other corner portion of the one short side, a first outer electrode 11 a (see Fig. 3A) electrically connected to the first through-electrode 10a on the one corner portion of the other short side, and a dummy electrode 11c formed on the other corner portion.

The piezoelectric vibrating reed 4 is made of a rectangular thin plate and includes first and second excitation electrodes 6a and 6b (see Fig. 3A) for driving the piezoelectric vibrating reed 4 on both sides. The piezoelectric vibrating reed 4 further includes first and second terminal electrodes 12a and 12b extending from one surface in the vicinity of one short side via a side surface of the short side over to the other surface, and the first terminal electrode 12a is connected to the first excitation electrode 6a and the second terminal electrode 12b is connected to the second excitation electrode 6b. The piezoelectric vibrating reed 4 is mounted on the first and second mounting portions 9a and 9b in a cantilevered state.

The lid substrate 3 has the concave portion 16 on its surface on the base substrate 2 side and can accommodate the piezoelectric vibrating reed 4. A bottom surface 15 of the concave portion 16 is a flat surface, and includes a second lead-out electrode 5b formed along the vicinity of the one long side. When the lid substrate 3 is bonded to the base substrate 2, an upper surface of the first connection portion 7a comes in contact with the second lead-out electrode 5b in the vicinity of the one short side, and an upper surface of the second connection portion 7b comes in contact with the second lead-out electrode 5b in the vicinity of the other short side. Accordingly, the first and second lead-out electrodes 5a and 5b are electrically connected to each other via the first and second connection portions 7a and 7b in the vicinity of the one short side, that is, the vicinity of the first mounting portion 9a and in the vicinity of the other short side, that is, the vicinity of the first through-electrode 10a.

Detailed description will be provided with reference to Figs. 2A to 3B. The bonding member 13 made of, for example, aluminum, silicon, or the like is provided on the outer peripheral portion of the base substrate 2. The second through-electrode 10b is provided in the corner portion between the one short side (hereinafter, referred to as a lower side) and a right side on the inner peripheral side of the bonding member 13 of the base substrate 2, and the first through-electrode 10a is provided in a corner region between the other short side (hereinafter, referred to as an upper side) and a left side. A conductive adhesive material or metal may be used for the first and second through-electrodes 10a and 10b. When metal is used to weld its surface to the glass material, airtightness can be maintained for a long time.

The first and third lead-out electrodes 5a and 5c are separated from each other on the inner peripheral side of the bonding member 13 and on the surface H of the base substrate 2. The first lead-out electrode 5a is formed to extend from a corner region between the lower side and the left side on the inner peripheral side of the bonding member 13 to the other short side (hereinafter, referred to as the upper side) along the left side and to cover the upper surface of the first through-electrode 10a and is electrically connected to the first through-electrode 10a. The third lead-out electrode 5c is formed to cover the upper surface of the second through-electrode 10b in a corner portion between the lower side and the left side on the inner peripheral side of the bonding member 13 and is electrically connected to the second through-electrode 10b. In addition, the concave portion 16 is formed on the surface of the lid substrate 3 on the piezoelectric vibrating reed 4 side, and the bottom surface 15 thereof on its left side is provided with the second lead-out electrode 5b. A metal film, for example, Au/Cr may be used for the first, second, and third lead-out electrodes 5a, 5b, and 5c.

The first and second mounting portions 9a and 9b (see Fig. 1 B) which are separated from each other are provided on the first and third lead-out electrodes 5a and 5c in the vicinity of the lower side, and the piezoelectric vibrating reed 4 is mounted thereon in the cantilevered state. In addition, the first and second connection portions 7a and 7b are formed on the first lead-out electrode 5a in the corner region between the lower side and the left side and in the corner region between the upper side and the left side. A conductive adhesive material or a metal bump can be used for the first and second mounting portions 9a and 9b and the first and second connection portions 7a and 7b. When the metal bump is used, the metal bump solidifies within a short time when the piezoelectric vibrating reed 4 is pressure-bonded, so that the metal bump is very suitable for mounting the piezoelectric vibrating reed 4 in the cantilevered state.

The first mounting portion 9a is electrically connected to the first terminal electrode 12a formed on the lower side of the piezoelectric vibrating reed 4, and the second mounting portion 9b is electrically connected to the second terminal electrode 12b formed on the lower side of the piezoelectric vibrating reed 4. In addition, the first and second lead-out electrodes 5a and 5b respectively conduct with the first and second connection portions 7a and 7b. Moreover, as viewed in a direction normal to the surface H of the base substrate 2, the first and second excitation electrodes 6a and 6b provided in the piezoelectric vibrating reed 4 are installed so as not to overlap with the first and second lead-out electrodes 5a and 5b.

As a result, the first excitation electrode 6a is electrically connected to the first outer electrode 11 a via the first terminal electrode 12a, the first mounting portion 9a, the first and second lead-out electrodes 5a and 5b, and the first through-electrode 10a, and the second excitation electrode 6b is electrically connected to the second outer electrode 11 b via the second terminal electrode 12b, the second mounting portion 9b, the third lead-out electrode 5c, and the second through-electrode 10b. Therefore, as a drive power is applied to the first and second outer electrodes 11 a and 11 b to vibrate the piezoelectric vibrating reed 4, a frequency signal can be obtained by the first and second outer electrodes 11 a and 11 b.

In this configuration, the first and second lead-out electrodes 5a and 5b are electrically connected to the first and second connection portions 7a and 7b and thus in a parallel connection, so that lead-out resistance can be reduced to, for example, 1/2. In addition, since the first and second lead-out electrodes 5a and 5b do not overlap with the first and second excitation electrodes 6a and 6b in the plan view, parasitic capacitance of the lead-out electrode can be reduced, thereby stabilizing vibration. Moreover, in the first embodiment, the concave portion is provided in the lid substrate 3. However, instead of this, the concave portion may be provided in the base substrate 2.

### Second Embodiment

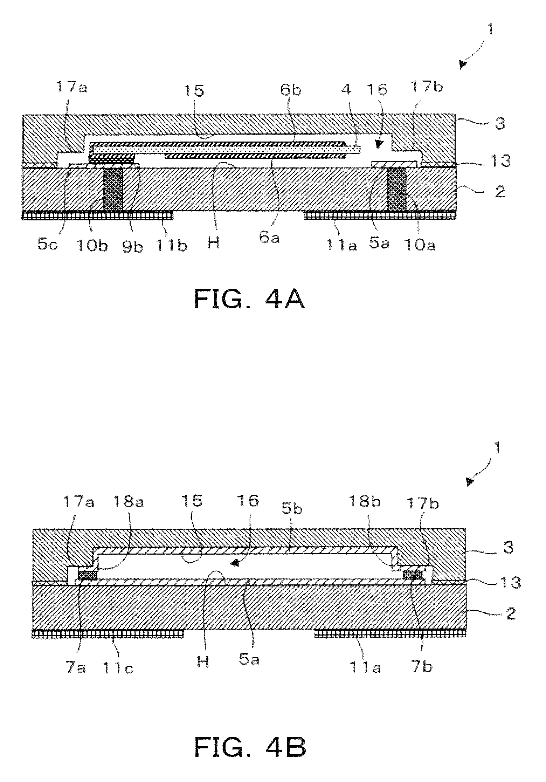

Figs. 4A and 4B are cross-sectional views schematically illustrating the piezoelectric vibrator 1 according to a second embodiment of the invention. Fig. 4A is a cross-sectional view schematically illustrating the piezoelectric vibrator taken along the line B-B of Figs. 2A and 2B, and Fig. 4B is a cross-sectional view schematically illustrating the piezoelectric vibrator taken along the line A-A of Figs. 2A and 2B. This embodiment is different from the first embodiment in that a stepped portion 17 is provided between an inner wall and the bottom surface 15 of the concave portion 16 of the lid substrate 3 and a stepped electrode 18 is provided on a surface of the stepped portion 17, and other components are the same as those of the first embodiment. Therefore, hereinafter, the different components from those of the first embodiment will be mainly described. Like elements which are the same or have the same functions are denoted by like reference numerals.

As illustrated in Figs. 4A and 4B, a first stepped portion 17a and a second stepped portion 17b are provided between the side wall and the bottom surface 15 of the concave portion 16 of the lid substrate 3. Upper surfaces of the first and second stepped portions 17a and 17b have substantially the same distance from the surface H of the base substrate 2 as a distance of the piezoelectric vibrating reed 4 on the base substrate 2 side from the surface H. The upper surfaces and side surfaces of the first and second stepped portions 17a and 17b are provided with the first and second stepped electrodes 18a and 18b. The first stepped electrode 18a formed on the upper surface of the first stepped portion 17a is electrically connected to the first connection portion 7a, and the second stepped electrode 18b formed on the upper surface of the second stepped portion 17b comes in contact with and thus is electrically connected to the second connection portion 7b. In addition, an end portion of the lower side of the second lead-out electrode 5b provided on the bottom surface 15 of the concave portion 16 of the lid substrate 3 is electrically connected to the first stepped electrode 18a, and an end portion of the upper side of the second lead-out electrode 5b is electrically connected to the second stepped electrode 18b. Accordingly, the first and second lead-out electrodes 5a and 5b are connected in parallel to each other from the lower side to the upper side of the base substrate 2.

Since the stepped portion 17 is provided between the side wall and the bottom surface 15 of the concave portion 16 and the stepped electrode 18 is formed on the upper surface and the side surface thereof, the piezoelectric vibrating reed 4 can be simultaneously performed in the same step as a flip chip bonding by forming the first and second connection portions 7a and 7b of the same mounting members as the first and second mounting portions 9a and 9b, for example, metal bumps. Moreover, even in this case, the first and second lead-out electrodes 5a and 5b are formed so as not to overlap with the first and second excitation electrodes 6a and 6b formed on both surfaces of the piezoelectric vibrating reed 4.

Moreover, the first and second stepped portions 17a and 17b may be formed between walls corresponding to the lower side portion and the upper side portion of the base substrate 2 respectively on the concave portion 16 side and the bottom surface 15, or may be formed only in a region of the corner portion between the lower side portion and the left side portion and the corner portion between the upper side portion and the left side portion, where the first and second connection portions 7a and 7b are formed. Other configurations are the same as those of the first embodiment.

Although the stepped electrodes 18a, 18b are discussed as separate electrodes to the second lead-out electrode 5b (and they may all be formed separately but electrically connected), the stepped electrodes and the second lead-out electrode may be formed as an integral electrode.

### Third Embodiment

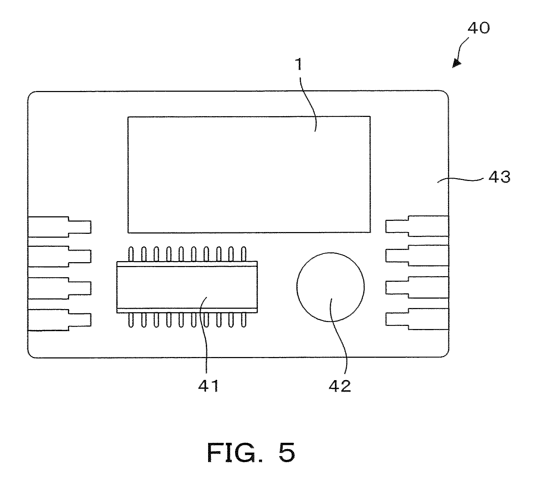

Fig. 5 is a top view schematically illustrating an oscillator 40 according to a third embodiment of the invention. As illustrated in Fig. 5, the oscillator 40 includes a substrate 43, the piezoelectric vibrator 1 installed on the substrate, an integrated circuit 41, and an electronic component 42. The piezoelectric vibrator 1 generates a signal with a predetermined frequency on the basis of a drive signal that may be transmitted to the outer electrodes 11 a and 11 b, and the integrated circuit 41 and the electronic component 42 process the signal with the predetermined frequency supplied from the piezoelectric vibrator 1 and generate a reference signal such as a clock signal. The piezoelectric vibrator 1 according to the invention can be formed with high reliability and to have a small size, thereby achieving a compact size for the oscillator 40.

The foregoing description has been given by way of example only and it will be appreciated by a person skilled in the art that modifications can be made without departing from the scope of the present invention.

For example, a rectangular shape is not required for any/all of the components, and the corners need not be right-angled. Moreover, the expression "corner" should be interpreted in a broad sense to encompass any corner region.

In addition, in the embodiments the concave portion is provided in the lid substrate 3. However, instead of this the concave portion may be provided in the base substrate 2. In this case, the first lead-out electrode 5a and the first and second mounting portions 9a and 9b may be formed on a bottom surface of the concave portion, and the first and second connection portions 7a and 7b may be formed on the bottom surface of the concave portion from an upper surface of the concave portion via its inner side surface.

Furthermore, in the embodiments the first and second through-electrodes 10a and 10b are installed in diagonally opposite regions of the rectangular base substrate 2. However, the invention is not limited to this, and the first and second through-electrodes 10a and 10b may be installed on the opposite sides to each other or on one of the sides.

## Claims

1. A piezoelectric vibrator (1) comprising:
a base substrate (2);
a piezoelectric vibrating reed (4) which is held on a mounting portion (9a, 9b) formed on a surface of the base substrate in a cantilevered state; and
a lid substrate (3) which is installed on the base substrate and covers the piezoelectric vibrating reed,
wherein the piezoelectric vibrating reed has first and second excitation electrodes (6a, 6b) on outer surfaces thereof for driving,
the base substrate has first and second through-electrodes (10a, 10b) which penetrate from the surface thereof to the rear surface on the reverse side, a first lead-out electrode (5a) which is formed on the surface thereof and has one end connected to the first through-electrode and the other end connected to the mounting portion, a first connection portion (7a) positioned on the first lead-out electrode in the vicinity of the mounting portion, and a second connection portion (7b) positioned in the vicinity of the first through-electrode,
the lid substrate has a second lead-out electrode (5b) formed on a surface on a side on which the piezoelectric vibrating reed is mounted, and the first and second lead-out electrodes are electrically connected to each other via the first and second connection portions, and
the first excitation electrode (6a) is electrically connected to the first through-electrode (10a) via the mounting portion (9a) and the first and second lead-out electrodes (5a, 5b), and the second excitation electrode (6b) is electrically connected to the second through-electrode (10b) via the mounting portion (9b).

2. The piezoelectric vibrator according to claim 1,
wherein the piezoelectric vibrating reed has a flat plate shape, and the first and second excitation electrodes are formed on the front and the rear surface of the flat panel shape to be opposite to each other, and
the first and second lead-out electrodes are installed at positions so as not to overlap with the first and second excitation electrodes as viewed in a direction normal to the surface of the base substrate.

3. The piezoelectric vibrator according to claim 1 or 2,
wherein the lid substrate has a concave portion (16) for accommodating the piezoelectric vibrating reed,
an upper surface of a side wall of the concave portion is bonded to the base substrate,
first and second stepped portions (17a, 17b) are formed between the upper surface of the side wall and a bottom surface of the concave portion,
first and second stepped electrodes (18a, 18b) are formed on upper and side surfaces of the first and second stepped portions, respectively, and
the first stepped electrode electrically connects one end of the second lead-out electrode to the first connection portion, and the second stepped electrode electrically connects the other end of the second lead-out electrode to the second connection portion.

4. An oscillator (40) comprising:
the piezoelectric vibrator according to any one of claims 1 to 3; and
a drive circuit (41) for supplying a drive signal to the piezoelectric vibrator.
